# EUROPEAN PATENT APPLICATION

(11) **EP 4 429 442 A1**
(43) Date of publication of application: **11.09.2024**
(21) Application number: 24158851.6
(22) Date of filing: 21.02.2024
(51) Int. Cl.: H10K 59/122, H10K 50/81, H10K 50/816

(54) **DISPLAY PANEL AND METHOD OF MANUFACTURING THE SAME**

(30) Priority: 07.03.2023 KR 20230030004
(71) Applicant: Samsung Display Co., Ltd., Gyeonggi-Do (KR)
(72) Inventor: SHIN, Hyuneok, Yongin-si (KR); SONG, Dokeun, Yongin-si (KR); LEE, Juhyun, Yongin-si (KR); CHUNG, Yung Bin, Yongin-si (KR)
(74) Representative: Marks & Clerk LLP

(57) **Abstract**

A display panel includes: a base layer (BS) including a display region (AA) and a non-display region (NAA), where the display region has a first light-emitting region (PXA-1), a second light-emitting region (PXA-2), and a non-light-emitting region (NPXA); a first lower electrode (LE1) disposed on the base layer and overlapping the first light-emitting region; a second lower electrode (LE2) disposed on the base layer and overlapping the second light-emitting region; and a filling layer (FL) disposed on the base layer and between the first lower electrode and the second lower electrode. The filling layer includes an inorganic material containing silicon and an organic material, and covers at least a portion of a side surface of each of the first lower electrode and the second lower electrode.

## Description

### BACKGROUND

The present disclosure herein relates to a display panel and a method of manufacturing the display panel, and more particularly, to a display panel with improved durability and reliability.

A display device, such as a television, a monitor, a smartphone, and a tablet computer, which provides images to users includes a display panel which displays images. Various display panels such as a liquid crystal display panel, an organic light-emitting display panel, an electro-wetting display panel, and an electrophoretic display panel are being developed as a display panel.

Studies are being conducted on a method for patterning a light-emitting element to improve the reliability of a display panel. Studies are being conducted on a high-resolution display device including a light-emitting material commonly provided by using an open mask.

### SUMMARY

The present disclosure provides a display panel with which a high-resolution image is achieved and which has improved durability and reliability, and a method of manufacturing the same.

An embodiment of the invention provides a display panel including: a base layer including a display region and a non-display region, wherein the display region has a first light-emitting region, a second light-emitting region, and a non-light-emitting region; a first lower electrode disposed on the base layer and overlapping the first light-emitting region; a second lower electrode disposed on the base layer and overlapping the second light-emitting region; and a filling layer disposed on the base layer and between the first lower electrode and the second lower electrode, where the filling layer includes a first inorganic material containing silicon and a first organic material, and covers at least a portion of a side surface of each of the first lower electrode and the second lower electrode.

In an embodiment, the filling layer may not be disposed above each of the first lower electrode and the second lower electrode.

In an embodiment, the first organic material may include at least one of siloxane, polyimide, or an acrylate-based polymer, and the first inorganic material may include at least one of silicon dioxide (SiO₂), silicon nitride (Si₃N₄), or silicon oxynitride (SiON).

In an embodiment, the filling layer may contain the first organic material in an amount of about 10 percentage by weight (wt%) to about 50 wt% with respect to the total content of the filling layer.

In an embodiment, the first lower electrode may include a first electrode upper surface, the second lower electrode may include a second electrode upper surface, and the filling layer may include a first upper surface, and the first upper surface is disposed lower than at least one of the first electrode upper surface or the second electrode upper surface.

In an embodiment, the first upper surface may have a recessed curved shape such that the first upper surface becomes more adjacent to the base layer in a direction away from each of the first electrode upper surface and the second electrode upper surface.

In an embodiment, the first lower electrode may have a first thickness, and the second lower electrode may have a second thickness different from the first thickness.

In an embodiment, the second thickness may be larger than the first thickness, the filling layer may include a first portion adjacent to the first lower electrode; and a second portion adjacent to the second lower electrode, and a thickness of the second portion may be greater than a thickness of the first portion.

In an embodiment, the display region may further include a third light-emitting region, the display panel may further include a third lower electrode disposed on the base layer and overlapping the third light-emitting region, and the filling layer may be disposed between the second lower electrode and the third lower electrode.

In an embodiment, a thickness of the third lower electrode may be different from each of a thickness of the first lower electrode and a thickness of the second lower electrode.

In an embodiment, the first lower electrode and the second lower electrode may each include: a first layer including a reflective metal material; and a second layer disposed on the first layer and including a transparent conductive oxide.

In an embodiment, the filling layer may be in contact with a side surface of each of the first layer and the second layer.

In an embodiment, the display panel may further include: at least one organic layer disposed on the first lower electrode and the second lower electrode and including a light-emitting layer; and an upper electrode disposed on the at least one organic layer.

In an embodiment, the display panel may further include: an encapsulation layer disposed on the upper electrode; and a plurality of color filters disposed on the encapsulation layer and provided in the first light-emitting region and second light-emitting region, respectively.

In an embodiment, the first lower electrode and the second lower electrode may be disposed in the same layer.

In an embodiment, the filling layer may be in contact with the side surface of each of the first lower electrode and the second lower electrode and include a lower surface aligned with a lower surface of each of the first lower electrode and the second lower electrode.

In an embodiment of the invention, a display panel includes: a base layer which includes a display region and a non-display region, where the display region has a first light-emitting region, a second light-emitting region, and a non-light-emitting region; a first lower electrode disposed on the base layer and overlapping the first light-emitting region; a second lower electrode disposed on the base layer and overlapping the second light-emitting region; and a filling layer disposed on the base layer and between the first lower electrode and the second lower electrode, wherein the filling layer includes a first inorganic material and a first organic material, covers at least a portion of a side surface of each of the first lower electrode and the second lower electrode, and is not disposed above each of the first lower electrode and the second lower electrode.

In an embodiment of the invention, a method of manufacturing a display panel includes: providing a preliminary display panel including a base layer, a first lower electrode disposed on the base layer, and a second lower electrode disposed on the base layer and spaced apart from the first lower electrode; and providing a filling material between the first lower electrode and the second lower electrode to form a filling layer, wherein the filling material includes a first inorganic material containing silicon and a first organic material, and the filling layer is formed to cover at least a portion of a side surface of each of the first lower electrode and the second lower electrode.

In an embodiment, the method may further include, after the filling layer is formed, ashing an upper surface of each of the first lower electrode and the second lower electrode.

In an embodiment, the first lower electrode may include a first electrode upper surface, the second lower electrode may include a second electrode upper surface; and an upper surface of the filling layer may be formed to be disposed lower than at least one of the first electrode upper surface or the second electrode upper surface.

At least some of the above and other features of the invention are set out in the claims.

### BRIEF DESCRIPTION OF THE FIGURES

The accompanying drawings are included to provide a further understanding of the invention, and are incorporated in and constitute a part of this specification. The drawings illustrate embodiments of the invention and, together with the description, serve to explain principles of the invention. In the drawings:
FIG. 1A is a perspective view of an electronic device according to an embodiment of the invention;
FIG. 1B is an exploded perspective view of an electronic device according to an embodiment of the invention;
FIG. 2 is a plan view of a display panel according to an embodiment of the invention;
FIG. 3 is a cross-sectional view of a display panel according to an embodiment of the invention;
FIGS. 4A to 4C are cross-sectional views illustrating some components of a display panel, respectively, according to an embodiment of the invention;
FIGS. 5A and 5B are cross-sectional views of a light-emitting element, respectively, according to an embodiment;
FIGS. 6A to 6C are cross-sectional views illustrating some operations of a method of manufacturing a display panel according to an embodiment of the invention;
FIGS. 7A and 7B are cross-sectional views illustrating some operations of a method of manufacturing a display panel according to an embodiment of the invention; and
FIG. 8 is a perspective view of an electronic device according to an embodiment of the invention.

### DETAILED DESCRIPTION

Hereinafter, the invention will be described in detail with reference to the accompanying drawings.

In this specification, it will be understood that when an element (or a region, a layer, a portion, or the like) is referred to as "being on", "connected to" or "coupled to" another element, it may be directly disposed on/connected/coupled to the other element, or intervening elements may be disposed therebetween.

Like reference numerals or symbols refer to like elements throughout. In the drawings, the thickness, the ratio, and the dimension of the elements are exaggerated for effective description of the technical contents. "At least one" is not to be construed as limiting "a" or "an." "Or" means "and/or." The term "and/or" includes all combinations of one or more of the associated listed elements.

Although the terms "first", "second", etc. may be used to describe various elements, these elements should not be limited by these terms. These terms are only used to distinguish one element from another element. For example, a first element may be referred to as a second element, and similarly, a second element may also be referred to as a first element without departing from the scope of the invention. The singular forms include the plural forms as well, unless the context clearly indicates otherwise.

The terms such as "below", "lower", "above", "upper" and the like, may be used herein for the description to describe one element's relationship to another element illustrated in the figures. It will be understood that the terms have a relative concept and are described on the basis of the orientation depicted in the figures.

It will be understood that the term "includes" or "comprises", when used in this specification, specifies the presence of stated features, integers, steps, operations, elements, components, or a combination thereof, but does not preclude the presence or addition of one or more other features, integers, steps, operations, elements, components, or combinations thereof.

In this specification, it will be understood that "being directly disposed on" means that there are no intervening layers, films, regions, plates, or the like between a portion of layers, films, regions, plates, or the like and another portion. For example, "being directly disposed on" may mean to be disposed between two layers or two members without using an additional member such as an adhesive member or the like.

Unless otherwise defined, all terms (including technical and scientific terms) used herein have the same meaning as commonly understood by one of ordinary skill in the art to which the present disclosure belongs. Also, terms, such as those defined in commonly used dictionaries, should be interpreted as having a meaning that is consistent with their meaning in the context of the relevant art and should not be interpreted in an idealized or overly formal sense unless expressly so defined herein.

"About" or "approximately" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value. Hereinafter, an electronic device according to an embodiment of the invention and a display panel included therein will be described with reference to the accompanying drawings.

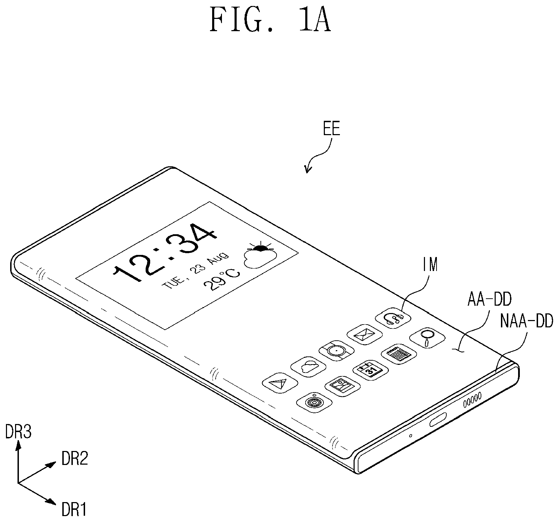

FIG. 1A is a perspective view of an electronic device according to an embodiment of the invention.

Referring to FIG. 1A, an electronic device EE may be a device activated in response to an electrical signal. For example, the electronic device EE may be a television, a monitor, an external billboard, a game console, a personal computer, a laptop computer, a mobile phone, a tablet computer, a car navigation system, and a wearable device, but an embodiment of the invention is not limited thereto. In FIG. 1A, a mobile phone is exemplarily illustrated as the electronic device EE. The electronic device EE may display an image IM through an active region AA-DD. The active region AA-DD may include a flat surface defined by a first direction DR1 and a second direction DR2. The active region AA-DD may include a curved surface bent from at least one side of the flat surface defined by the first direction DR1 and the second direction DR2. However, this is merely an example, and a shape of the active region AA-DD is not limited thereto. In another embodiment, for example, the active region AA-DD may include only the flat surface or may further include the at least two curved surfaces, for example, four curved surfaces bent from four side surfaces of the flat surface, respectively.

In FIG. 1A and the following drawings, the first direction DR1 to a third direction DR3 are illustrated, and the directions indicated by the first to third directions DR1, DR2, and DR3 illustrated herein may have a relative concept and may thus be changed to other directions. In this specification, the first direction DR1 and the second direction DR2 may be orthogonal to each other, and the third direction DR3 may be a normal direction of a plane defined by the first direction DR1 and the second direction DR2.

A thickness direction of the electronic device EE may be a direction parallel to the third direction DR3 which is a normal direction of a plane defined by the first direction DR1 and the second direction DR2. In this specification, a front surface (or upper surface) and a rear surface (or lower surface) of each member constituting the electronic device EE may be defined on the basis of the third direction DR3. In this specification, the wording "on a plane" means "on a surface parallel to a plane defined by the first direction DR1 and the second direction DR2", which has the same meaning with "in a plan view" and the wording "on a cross section" means "on a surface parallel to the third direction DR3".

A peripheral region NAA-DD may be adjacent to the active region AA-DD. The peripheral region NAA-DD may surround the active region AA-DD. Accordingly, a shape of the active region AA-DD may be substantially defined by the peripheral region NAA-DD. However, this is illustrated as an example, and the peripheral region NAA-DD may be disposed adjacent to only one side of the active region AA-DD or may be omitted. The active region AA-DD may have various shapes, and is not limited to any one embodiment.

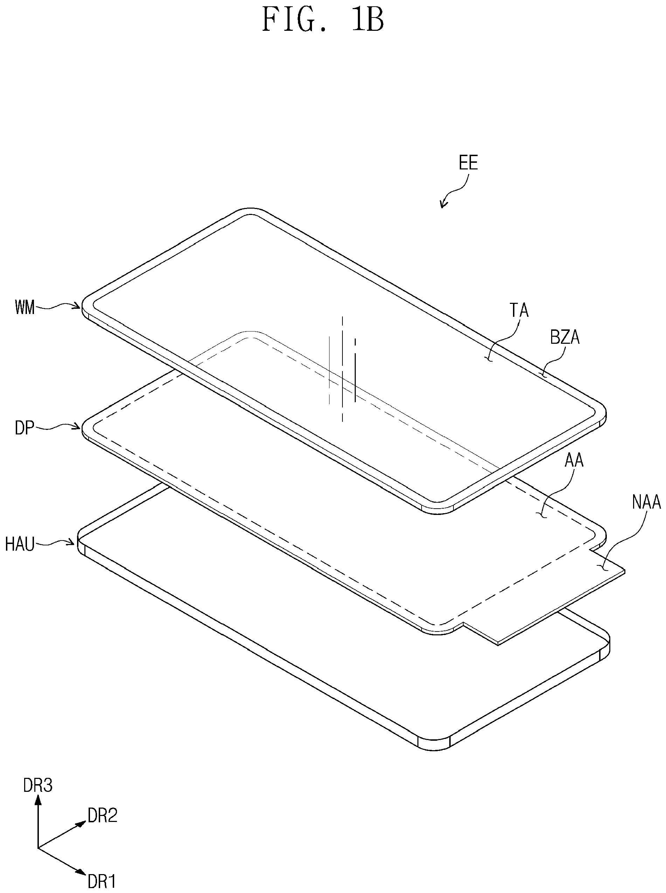

FIG. 1B is an exploded perspective view of an electronic device according to an embodiment of the invention. Referring to FIG. 1B, an electronic device EE may include a housing HAU, a display panel DP, and a window member WM.

The window member WM may cover the entire exterior of the display panel DP. The window member WM may include a transmission region TA and a bezel region BZA. The front surface of the window member WM including the transmission region TA and the bezel region BZA may correspond to the front surface of the electronic device EE. The transmission region TA may correspond to the active region AA-DD of the electronic device EE illustrated in FIG. 1A, and the bezel region BZA may correspond to the peripheral region NAA-DD of the electronic device EE illustrated in FIG. 1A.

The transmission region TA may be an optically transparent region. The bezel region BZA may be a region having a relatively lower light transmittance than the transmission region TA. The bezel region BZA may have a predetermined color. The bezel region BZA may be adjacent to the transmission region TA and surround the transmission region TA. The bezel region BZA may define a shape of the transmission region TA. However, an embodiment of the invention is not limited to what is illustrated in the drawings. The bezel region BZA may be disposed adjacent only to one side of the transmission region TA or a portion thereof may be omitted.

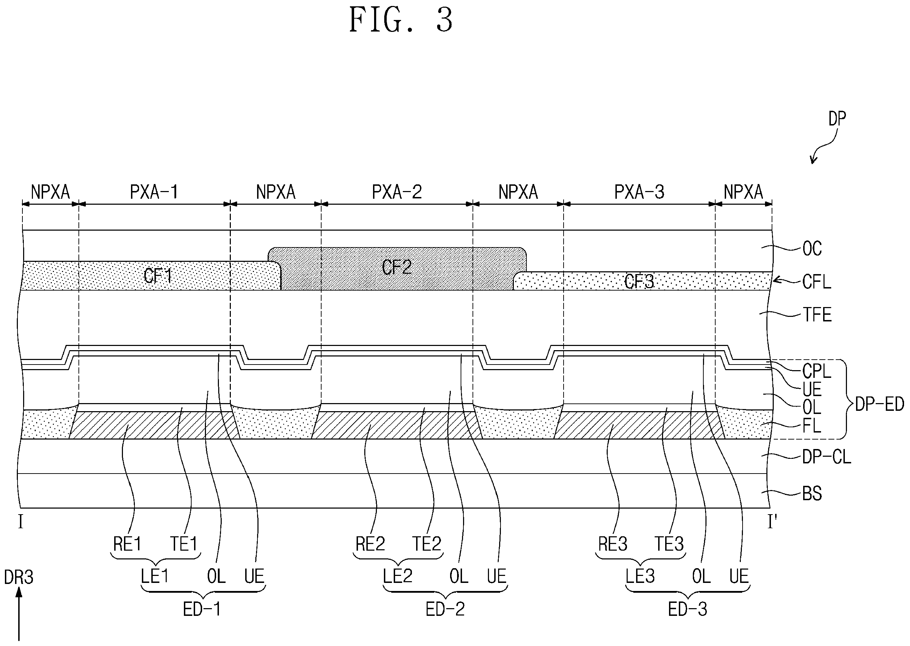

The display panel DP may include a display region AA and a non-display region NAA surrounding the display region AA. The display region AA may correspond to the transmission region TA, and the non-display region NAA may correspond to the bezel region BZA. Although not illustrated in the drawing, an input-sensing portion may be provided on the display panel DP. The input-sensing portion may detect an external input applied from the outside. The external input may be a user's input. The user's input may include various types of external inputs such as a part of a user's body, light, heat, pen, pressure, or the like. More specifically, the input-sensing portion (not illustrated) may be disposed on a later-described encapsulation layer TFE (see FIG. 3) of the display panel DP. Alternatively, the input-sensing portion (not illustrated) may be directly disposed on the encapsulation layer TFE (see FIG. 3) or on an adhesive member (not illustrated) disposed on the encapsulation layer TFE (see FIG. 3). The adhesive member may include a typical bonding agent or adhesive agent.

In this specification, it will be understood that when an element (or a region, a layer, a portion, or the like) is referred to as "being directly on" another element, intervening elements are not disposed therebetween. That is, the wording, "an element is 'directly disposed on' another element" means that the element is "in contact with" the other element.

The housing HAU may accommodate the display panel DP, and the like. The housing HAU may be coupled to the window member WM.

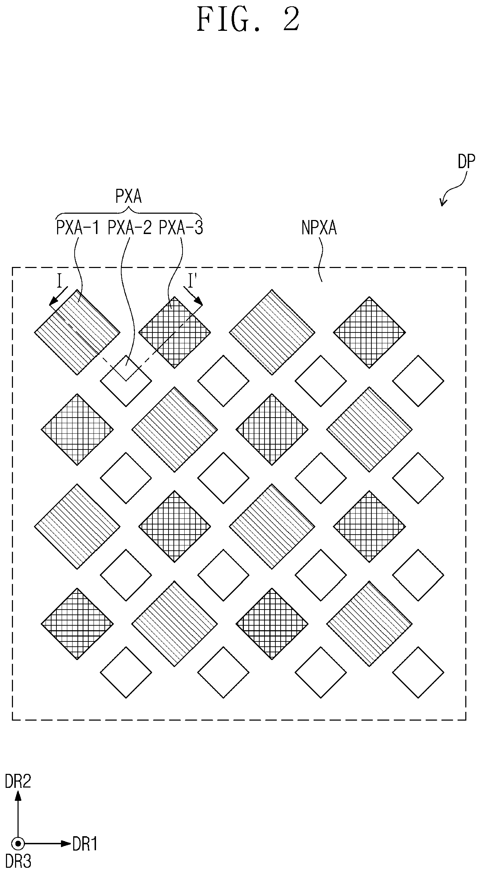

FIG. 2 is a plan view of a display panel according to an embodiment of the invention. Hereinafter, the following description of a display panel DP may be similarly applied to the display panel DP included in the electronic device EE illustrated in FIGS. 1A and 1B.

Referring to FIG. 2, the display region AA of the display panel DP may include a light-emitting region PXA and a non-light-emitting region NPXA. The non-light-emitting region NPXA may surround the light-emitting region PXA. The light-emitting region PXA may be provided in plurality. The light-emitting region PXA may include a first light-emitting region PXA-1, a second light-emitting region PXA-2, and a third light-emitting region PXA-3. The first light-emitting region PXA-1, the second light-emitting region PXA-2, and the third light-emitting region PXA-3 may emit light having different wavelength ranges, respectively. The first light-emitting region PXA-1 may emit first light, and the second light-emitting region PXA-2 may emit second light different from the first light. The third light-emitting region PXA-3 may emit third light different from each of the first light and the second light.

Among the first to third light-emitting regions PXA-1, PXA-2, and PXA-3, the first light-emitting region PXA-1 may have the greatest area, and the second light-emitting region PXA-2 may have the smallest area. However, this is merely an example, and the areas of the first to third light-emitting regions PXA-1, PXA-2, and PXA-3 are not limited thereto. FIG. 3 illustrates that the first light-emitting region PXA-1 and the third light-emitting region PXA-3 are alternately arranged in one row, and the second light-emitting region PXA-2 is arranged in another row while being spaced apart from the first light-emitting region PXA-1 and the third light-emitting region PXA-3. However, this is merely an example, and arrangements of the first to third light-emitting regions PXA-1, PXA-2, and PXA-3 are not limited thereto.

FIG. 3 is a cross-sectional view of a display panel according to an embodiment of the invention. FIG. 3 is a cross-sectional view illustrating a portion taken along line I-I' of FIG. 2.

Referring to FIG. 3, a display panel DP may include a base layer BS, a circuit layer DP-CL disposed on the base layer BS, a display element layer DP-ED disposed on the circuit layer DP-CL, and an encapsulation layer TFE disposed on the display element layer DP-ED. In addition, the display panel DP may further include a color filter layer CFL disposed on the encapsulation layer TFE.

Referring to FIG. 3, the base layer BS may be a member which provides a base surface on which the circuit layer DP-CL is disposed. The base layer BS may be a rigid substrate or a flexible substrate capable of bending, folding, rolling, and the like. The base layer BS may be a glass substrate, a metal substrate, a polymer substrate, or the like. However, an embodiment of the invention is not limited thereto, and the base layer BS may be an inorganic layer, an organic layer, or a composite material layer in another embodiment.

The base layer BS may have a single- or multi-layered structure. In an embodiment, for example, the base layer BS may include a first synthetic resin layer, a multi- or single-layered intermediate layer, and a second synthetic resin layer which are sequentially stacked. The intermediate layer may be referred to as a base barrier layer. The intermediate layer may include a silicon oxide (SiOₓ) layer and an amorphous silicon (a-Si) layer disposed on the silicon oxide layer, but is not particularly limited thereto. In an embodiment, for example, the intermediate layer may include at least one of a silicon oxide layer, a silicon nitride layer, a silicon oxynitride layer, or an amorphous silicon layer.

The first and second synthetic resin layers may each include a polyimide-based resin. In addition, the first and second synthetic resin layers may each include at least one of an acrylate-based resin, a methacrylate-based resin, a polyisoprene-based resin, a vinyl-based resin, an epoxy-based resin, a urethane-based resin, a cellulose-based resin, a siloxane-based resin, a polyimide-based resin, or a perylene-based resin. In this specification, an "a"-based resin may be considered as including a functional group of "a".

The circuit layer DP-CL may be disposed on the base layer BS. The circuit layer DP-CL may include an insulating layer, a semiconductor pattern, a conductive pattern, a signal line, and the like. After an insulating layer, a semiconductor layer, and a conductive layer are formed on the base layer BS through coating, deposition, etc., the insulating layer, the semiconductor layer, and the conductive layer may be selectively patterned by performing a photolithography process multiple times. Thereafter, the semiconductor pattern, the conductive pattern, and the signal line included in the circuit layer DP-CL may be formed.

The display element layer DP-ED may be disposed on the circuit layer DP-CL. The display element layer DP-ED may include first to third light-emitting elements ED-1, ED-2, and ED-3, a capping layer CPL, and a filling layer FL.

Referring to FIG. 3, the first to third light-emitting elements ED-1, ED-2, and ED-3 may be spaced apart from each other in one direction crossing the thickness direction DR3. The first to third light-emitting elements ED-1, ED-2, and ED-3 may include lower electrodes LE1, LE2, and LE3, an organic layer OL disposed on the lower electrodes LE1, LE2, and LE3, and an upper electrode UE disposed on the organic layer OL, respectively. In addition, the display element layer DP-ED may include the capping layer CPL disposed on the upper electrode UE.

The lower electrodes LE1, LE2, and LE3 may include first layers RE1, RE2, and RE3 and second layers TE1, TE2, and TE3 which are sequentially stacked, respectively. The lower electrodes LE1, LE2, and LE3 may each include one electrode having a two-layered structure in which the first layers RE1, RE2, and RE3 and the second layers TE1, TE2, and TE3 are stacked. Although not illustrated in the drawing, the lower electrodes LE1, LE2, and LE3 may each further include a base layer (not illustrated) disposed under the first layers RE1, RE2, and RE3. In an embodiment, for example, the base layer may include a transparent conductive oxide. In this specification, the lower electrodes LE1, LE2, and LE3 may be considered as "anodes". The lower electrodes LE1, LE2, and LE3 will be described later in more detail.

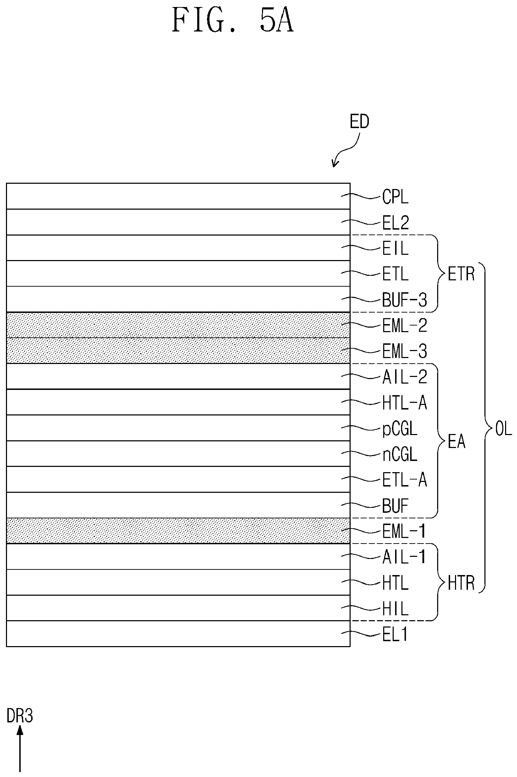

In the first to third light-emitting elements ED-1, ED-2, and ED-3, the organic layer OL may be provided as a common layer. The organic layer OL may include at least one light-emitting layer. The first to third light-emitting elements ED-1, ED-2, and ED-3 may each be a light-emitting element having a tandem structure. The organic layer OL may overlap first to third light-emitting regions PXA-1, PXA-2, and PXA-3 and the non-light-emitting region NPXA. In this specification, it will be understood that when an element is referred to as overlapping another element, it is not limited to a case of having the same area or shape on a plane, and also may include a case of having different areas and/or shapes. The organic layer OL may include at least a plurality of light-emitting layers EML-1, EML-2, and EML-3 (see FIG. 5A). The organic layer OL will be described later in more detail.

In the first to third light-emitting elements ED-1, ED-2, and ED-3, the upper electrode UE may be provided as a common electrode. The upper electrode UE may be a common layer overlapping all of the first to third light-emitting regions PXA-1, PXA-2, and PXA-3 and the non-light-emitting region NPXA and having an integral shape. In this specification, the upper electrode UE disposed on the organic layer OL may be considered as a "cathode".

The display element layer DP-ED may include a filling layer FL disposed between the lower electrodes LE1, LE2, and LE3. The filling layer FL may be disposed between the lower electrodes LE1, LE2, and LE3, and overlap the non-light-emitting region NPXA. The filling layer FL includes an organic material and an inorganic material. The filling layer FL will be described later in more detail.

The encapsulation layer TFE may be disposed on the display element layer DP-ED. The encapsulation layer TFE may protect the display element layer DP-ED against moisture, oxygen, and foreign substances such as dust particles. The encapsulation layer TFE may include at least one inorganic film (hereinafter, inorganic encapsulation film). In addition, the encapsulation layer TFE may include at least one organic film (hereinafter, organic encapsulation film) or at least one inorganic encapsulation film.

The inorganic encapsulation film may protect the display element layer DP-ED against moisture/oxygen, and the organic encapsulation film may protect the display element layer DP-ED against foreign substances such as dust particles. The inorganic encapsulation film may include silicon nitride, silicon oxynitride, silicon oxide, titanium oxide, aluminium oxide, or the like, but is not particularly limited thereto. The organic encapsulation film may include an acrylate-based compound, an epoxy-based compound, and the like. In an embodiment, the organic encapsulation film may include a photopolymerizable organic material, and is not particularly limited thereto.

The color filter layer CFL may be disposed on the encapsulation layer TFE. The color filter layer CFL may include a first filter CF1 corresponding to the first light-emitting region PXA-1, a second filter CF2 corresponding to the second light-emitting region PXA-2, and a third filter CF3 corresponding to the third light-emitting region PXA-3. Although not illustrated in the drawing, the color filter layer CFL may further include a light blocking portion (not illustrated). The light blocking portion may have a black matrix pattern. The light blocking portion may be formed by including an organic light blocking material or an inorganic light blocking material including a black pigment or a black dye. The light blocking portion may prevent light leakage and define boundaries between the filters CF1, CF2, and CF3 which are adjacent to each other.

The first to third filters CF1 to CF3 may each include a polymer photosensitive resin and a colorant. In this specification, the colorant may include a pigment and a dye. A red colorant includes a red pigment and a red dye, a green colorant includes a green pigment and a green dye, and a blue colorant includes a blue pigment and a blue dye.

FIG. 3 illustrates that the first filter CF1 may include a blue pigment and a blue dye, the second filter CF2 may include a green pigment and a green dye, and the third filter CF3 may include a red pigment and a red dye. That is, the first filter CF1 disposed on the first light-emitting element ED-1 may include a blue colorant, the second filter disposed on the second light-emitting element ED-2 may include a green colorant, and the third filter disposed on the third light-emitting element ED-3 may include a red colorant.

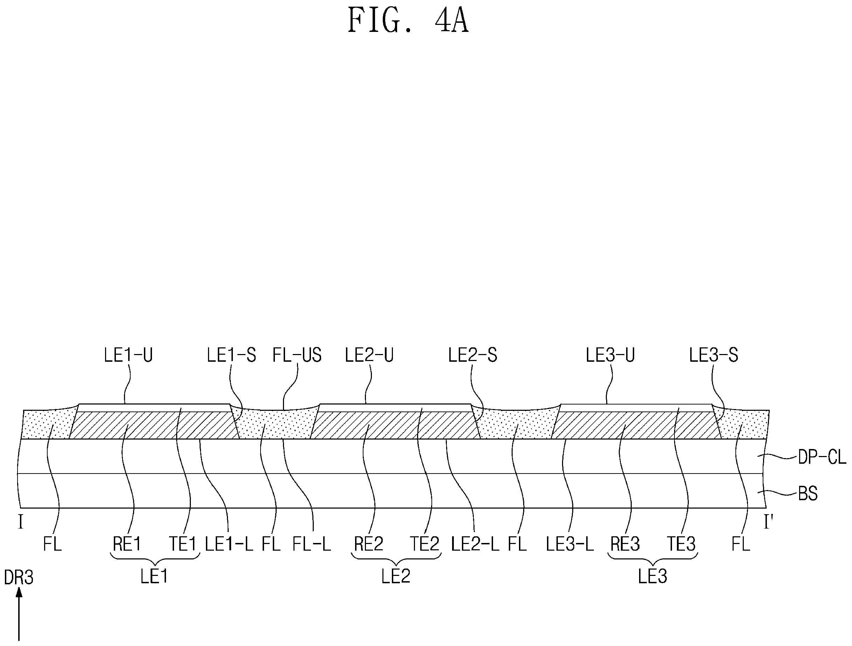

FIGS. 4A to 4C are cross-sectional views illustrating some components of a display panel, respectively, according to an embodiment of the invention. FIGS. 4A to 4C illustrate, among components of the display panel DP illustrated in FIG. 3, shapes of the lower electrodes LE1, LE2, and LE3 disposed on the circuit layer DP-CL and a shape of the filling layer FL disposed between the lower electrodes LE1, LE2, and LE3.

Referring to FIG. 3 and FIG. 4A together, the lower electrodes LE1, LE2, and LE3 may be disposed on the circuit layer DP-CL and include a first lower electrode LE1, a second lower electrode LE2, and a third lower electrode LE3. The first lower electrode LE1, the second lower electrode LE2, and the third lower electrode LE3 may be disposed to be spaced apart from each other. The first lower electrode LE1 may be disposed to overlap the first light-emitting region PXA-1, the second lower electrode LE2 may be disposed to overlap the second light-emitting region PXA-2, and the third lower electrode LE3 may be disposed to overlap the third light-emitting region PXA-3.

The first lower electrode LE1, the second lower electrode LE2, and the third lower electrode LE3 may each be disposed on the same layer. The first lower electrode LE1, the second lower electrode LE2, and the third lower electrode LE3 may each be disposed on the circuit layer DP-CL. The first lower electrode LE1, the second lower electrode LE2, and the third lower electrode LE3 may each be disposed on the uppermost layer among a plurality of insulating layers disposed on the circuit layer DP-CL. As illustrated in FIG. 4A, the first lower electrode LE1, the second lower electrode LE2, and the third lower electrode LE3 may each have the same thickness. However, an embodiment of the invention is not limited thereto, and the first lower electrode LE1, the second lower electrode LE2, and the third lower electrode LE3 may be different in thickness from each other in another embodiment.

The first lower electrode LE1, the second lower electrode LE2, and the third lower electrode LE3 may include first layers RE1, RE2, and RE3 and second layers TE1, TE2, and TE3 which are sequentially stacked, respectively. The first lower electrode LE1, the second lower electrode LE2, and the third lower electrode LE3 may each have one electrode having a two-layered structure in which the first layers RE1, RE2, and RE3 and the second layers TE1, TE2, and TE3 are stacked. The first lower electrode LE1 may include a (1-1)-th layer RE1 and a (2-1)-th layer TE1, the second lower electrode LE2 may include a (1-2)-th layer RE2 and a (2-2)-th layer TE2, and the third lower electrode LE3 may include a (1-3)-th layer RE3 and a (2-3)-th layer TE3.

The first layers RE1, RE2, and RE3 may each include a reflective metal material. The first layers RE1, RE2, and RE3 may each include any one of Ag, Mg, Cu, Al, Pt, Pd, Au, Ni, Nd, Ir, Cr, Li, Ca, LiF/Ca, LiF/Al, Mo, or Ti which has a high reflectivity. In an embodiment, for example, the first layers RE1, RE2, and RE3 may each include Ag.

The second layers TE1, TE2, and TE3 may each include a transparent conductive oxide. In an embodiment, the second layers TE1, TE2, and TE3 may each include at least one selected from the group including indium tin oxide ("ITO"), indium zinc oxide ("IZO"), indium gallium zinc oxide ("IGZO"), zinc oxide (ZnOₓ), or indium oxide (In₂O₃), and aluminium-doped zinc oxide ("AZO"). For example, the second layers TE1, TE2, and TE3 may each include indium tin oxide (ITO).

Although not illustrated in the drawing, the first lower electrode LE1, the second lower electrode LE2, and the third lower electrode LE3 may each further include a base layer (not illustrated) disposed under the first layers RE1, RE2, and RE3. In an embodiment, for example, the base layer may include a transparent conductive oxide.

The filling layer FL may be disposed between the lower electrodes LE1, LE2, and LE3 and be in contact with each of the lower electrodes LE1, LE2, and LE3. The filling layer FL may be disposed between the lower electrodes LE1, LE2, and LE3 and overlap the non-light-emitting region NPXA.

The filling layer FL may be disposed between the lower electrodes LE1, LE2, and LE3 and cover at least a portion of each of side surfaces LE1-S, LE2-S, and LE3-S of the respective lower electrodes LE1, LE2, and LE3. The filling layer FL may cover each of a first electrode side surface LE1-S of the first lower electrode LE1, a second electrode side surface LE2-S of the second lower electrode LE2, and a third electrode side surface LE3-S of the third lower electrode LE3. The filling layer FL may be in contact with each of the first electrode side surface LE1-S of the first lower electrode LE1, the second electrode side surface LE2-S of the second lower electrode LE2, and the third electrode side surface LE3-S of the third lower electrode LE3.

The filling layer FL may be in contact with each of the first layers RE1, RE2, and RE3 and the second layers TE1, TE2, and TE3 of the lower electrodes LE1, LE2, and LE3. The filling layer FL may be in contact with each of the side surfaces of the first layers RE1, RE2, and RE3 and the second layers TE1, TE2, and TE3 of the lower electrodes LE1, LE2, and LE3, and cover at least a portion of each of the side surfaces of the first layers RE1, RE2, and RE3 and the second layers TE1, TE2, and TE3. In an embodiment, the filling layer FL may cover the entirety of the side surfaces of the first layers RE1, RE2, and RE3 and cover a portion of the side surfaces of the second layers TE1, TE2, and TE3.

The filling layer FL may not be disposed on upper surfaces LE1-U, LE2-U, and LE3-U of the lower electrodes LE1, LE2, and LE3. The filling layer FL may be disposed to be in contact only with each of the side surfaces LE1-S, LE2-S, and LE3-S of the lower electrodes LE1, LE2, and LE3, and may not be in contact with each of the upper surfaces LE1-U, LE2-U, and LE3-U of the lower electrodes LE1, LE2, and LE3. The filling layer FL may be formed to be disposed on neither a first electrode upper surface LE1-U of the first lower electrode LE1, a second electrode upper surface LE2-U of the second lower electrode LE2, nor a third electrode upper surface LE3-U of the third lower electrode LE3. Since the filling layer FL may not be disposed on the upper surfaces LE1-U, LE2-U, and LE3-U of the lower electrodes LE1, LE2, and LE3 and exposes the upper surfaces LE1-U, LE2-U, and LE3-U of the lower electrodes LE1, LE2, and LE3, the organic layer OL may be directly disposed on the upper surfaces LE1-U, LE2-U, and LE3-U of the lower electrodes LE1, LE2, and LE3.

A first upper surface FL-US of the filling layer FL may be disposed to be lower than each of the upper surfaces LE1-U, LE2-U, and LE3-U of the lower electrodes LE1, LE2, and LE3. That is, the first upper surface FL-US of the filling layer FL may be defined to be more adjacent to the base layer BS than each of the upper surfaces LE1-U, LE2-U, and LE3-U of the lower electrodes LE1, LE2, and LE3. In other words, the height of the first upper surface FL-US of the filling layer FL from the upper surface of the base layer BS in the third direction DR3 may be lower than each of the heights of the upper surfaces LE1-U, LE2-U, and LE3-U from the upper surface of the base layer BS in the third direction DR3. The first upper surface FL-US of the filling layer FL may be disposed to be lower than each of the first electrode upper surface LE1-U of the first lower electrode LE1, the second electrode upper surface LE2-U of the second lower electrode LE2, and the third electrode upper surface LE3-U of the third lower electrode LE3.

The first upper surface FL-US of the filling layer FL may have a curved shape. The first upper surface FL-US of the filling layer FL may be disposed to be lower than each of the upper surfaces LE1-U, LE2-U, and LE3-U of the lower electrodes LE1, LE2, and LE3 and have a recessed curved shape to be adjacent to the base layer BS. The first upper surface FL-US of the filling layer FL may have a recessed curved shape such that the first upper surface FL-US becomes more adjacent to the base layer BS in a direction away from each of the upper surfaces LE1-U, LE2-U, and LE3-U of the lower electrodes LE1, LE2, and LE3.

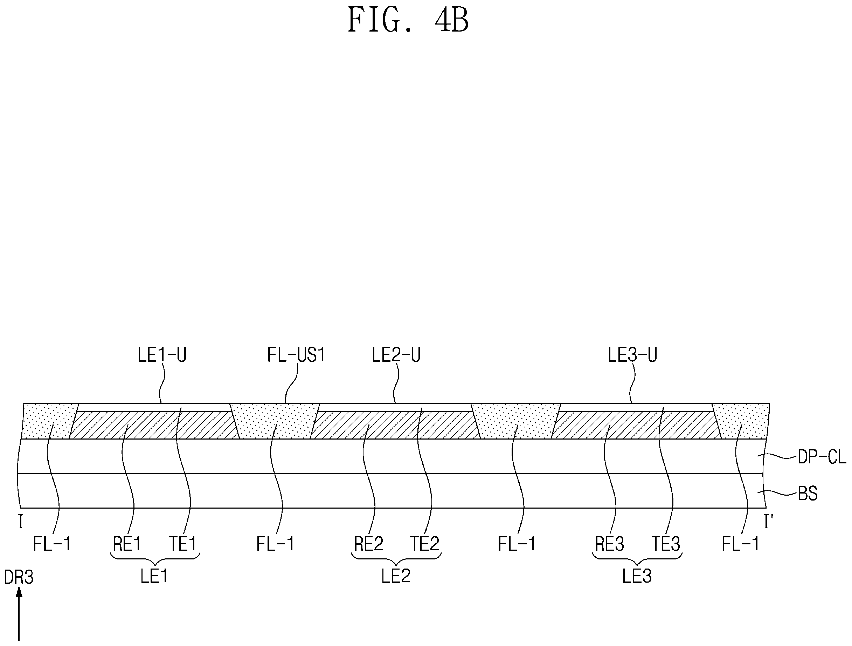

Referring to FIG. 4B, a first upper surface FL-US 1 of a filling layer FL-1 may not have a curved shape. The first upper surface FL-US 1 of the filling layer FL-1 may be coplanar with the upper surfaces LE1-U, LE2-U, and LE3-U of the lower electrodes LE1, LE2, and LE3. That is, the first upper surface FL-US1 may define one surface aligned with the upper surfaces LE1-U, LE2-U, and LE3-U of the lower electrodes LE1, LE2, and LE3. The first upper surface FL-US 1 of the filling layer FL-1 may be coplanar with the first electrode upper surface LE1-U of the first lower electrode LE1, the second electrode upper surface LE2-U of the second lower electrode LE2, and the third electrode upper surface LE3-U of the third lower electrode LE3.

The filling layer FL-1 may fully fill spaces defined between the lower electrodes LE1, LE2, and LE3. The filling layer FL-1 may cover the entirety of a side surface of each of the first layers RE1, RE2, and RE3 and the entirety of the second layers TE1, TE2, and TE3 of the lower electrodes LE1, LE2, and LE3, and fully fill spaces between the lower electrodes LE1, LE2, and LE3 such that the first upper surface FL-US1 of the filling layer FL-1 becomes coplanar with the upper surfaces LE1-U, LE2-U, and LE3-U of the lower electrodes LE1, LE2, and LE3.

Referring again to FIG. 4A, the filling layer FL includes a first organic material and a first inorganic material. The first inorganic material included in the filling layer FL is an inorganic material containing silicon. In an embodiment, the first inorganic material included in the filling layer FL may include at least one of silicon dioxide (SiO₂), silicon nitride (Si₃N₄), or silicon oxynitride (SiON). In an embodiment, for example, the first inorganic material may be silicon dioxide (SiO₂). The first organic material included in the filling layer FL may include at least one of siloxane, polyimide, or an acrylate-based polymer. In an embodiment, for example, the first organic material may be siloxane. The filling layer FL may be composed of the first inorganic material and the first organic material.

With regard to the first organic material and the first inorganic material included in the filling layer FL, the amount of the first inorganic material may be greater than the amount of the first organic material with respect to the total content of the filling layer FL. The filling layer FL may contain the first organic material in an amount of about 10 percentage by weight (wt%) to about 50 wt% with respect to the total content of the filling layer FL. When the filling layer FL contains the first organic material in an amount of less than about 10 wt%, a coating property of a filling material is deteriorated during the process of forming the filling layer FL, so that the filling layer FL may not be disposed only between the lower electrodes LE1, LE2, and LE3, but also formed on the upper surfaces LE1-U, LE2-U, and LE3-U of the lower electrodes LE1, LE2, and LE3. When the filling layer FL contains the first organic material in an amount of about 50 wt% or more, it is unlikely for the filling layer FL to be patterned so as to be disposed only between the lower electrodes LE1, LE2, and LE3 in a high-resolution display panel having a narrow interval between the lower electrodes LE1, LE2, and LE3.

The filling layer FL and the lower electrodes LE1, LE2, and LE3 may be disposed on the same layer. The filling layer FL may be disposed on the circuit layer DP-CL and may be disposed on the uppermost layer among a plurality of insulating layers included in the circuit layer DP-CL. The filling layer FL may cover a portion of the upper surface, of the circuit layer DP-CL, which is exposed because the lower electrodes LE1, LE2, and LE3 are not disposed thereon. A first lower surface FL-L of the filling layer FL and each of the lower surfaces LE1-L, LE2-L, and LE3-L of the lower electrodes LE1, LE2, and LE3 may be disposed on the same layer to define one aligned surface. The first lower surface FL-L of the filling layer FL may define one surface aligned with each of the first electrode lower surface LE1-L of the first lower electrode LE1, the second electrode lower surface LE2-L of the second lower electrode LE2, and the third electrode lower surface LE3-L of the third lower electrode LE3.

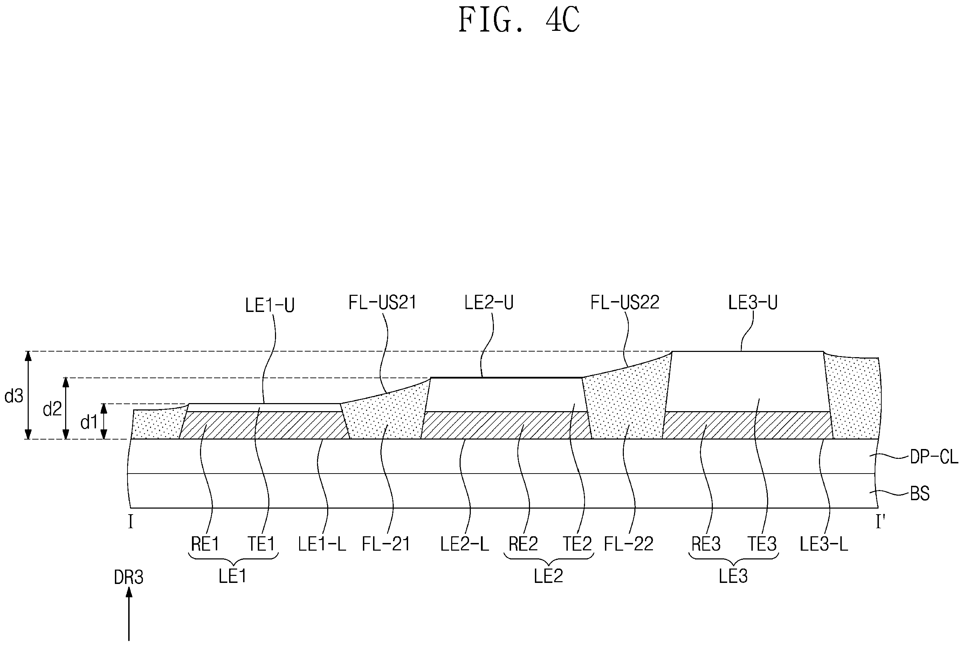

Referring to FIG. 4C, the lower electrodes LE1, LE2, and LE3 may have different thicknesses. In an embodiment, the thickness d1 of the first lower electrode LE1, the thickness d2 of the second lower electrode LE2, and the thickness d3 of the third lower electrode LE3 may be different from each other. As illustrated in FIG. 4C, the thickness d1 of the first lower electrode LE1 may be smaller than the thickness d2 of the second lower electrode LE2, and the thickness d2 of the second lower electrode LE2 may be smaller than the thickness d3 of the third lower electrode LE3.

The first layers RE1, RE2, and RE3 included in the lower electrodes LE1, LE2, and LE3, respectively, may have substantially the same thickness, and the second layers TE1, TE2, and TE3 may be different in thickness from each other. As illustrated in FIG. 4C, the (1-1)-th layer RE1 of the first lower electrode LE1, the (1-2)-th layer RE2 of the second lower electrode LE2, and the (1-3)-th layer RE3 of the third lower electrode LE3 may have substantially the same thickness, but the (2-1)-th layer TE1 of the first lower electrode LE1, the (2-2)-th layer TE2 of the second lower electrode LE2, and the (2-3)-th layer TE3 of the third lower electrode LE3 may be different in thickness from each other. In an embodiment, for example, the thickness of the (2-1)-th layer TE1 may be smaller than the thickness of the (2-2)-th layer TE2, and the thickness of the (2-2)-th layer TE2 may be smaller than the thickness of the (2-3)-th layer TE3. However, an embodiment of the invention is not limited thereto, and the first layers RE1, RE2, and RE3 included in the lower electrodes LE1, LE2, and LE3, respectively, may also be different in thickness from each other in another embodiment.

Filling layers FL-21 and FL-22 disposed between the lower electrodes LE1, LE2, and LE3 may be disposed between the lower electrodes LE1, LE2, and LE3 having different thicknesses from each other, and may be formed to be inclined. In an embodiment, the thickness d2 of the second lower electrode LE2 may be greater than the thickness d1 of the first lower electrode LE1, and the first filling layer FL-21 disposed between the first lower electrode LE1 and the second lower electrode LE2 may have an inclined shape such that the thickness of the first filling layer FL-21 becomes greater as getting closer to the second lower electrode LE2 from the first lower electrode LE1. A (1-1)-th upper surface FL-US21 of the first filling layer FL-21 and a (1-2)-th upper surface FL-US22 of the second filling layer FL-22 may each be an inclined surface. The (1-1)-th upper surface FL-US21 may be a surface inclined from a first height d1 defined by the first electrode upper surface LE1-U to a second height d2 defined by the second electrode upper surface LE2-U. The (1-2)-th upper surface FL-US22 may be a surface inclined from the second height d2 defined by the second electrode upper surface LE2-U to a third height d3 defined by the third electrode upper surface LE3-U.

The first filling layer FL-21 may include a first portion adjacent to the first lower electrode LE1 and a second portion adjacent to the second lower electrode LE2, and the thickness of the second portion may be greater than the thickness of the first portion. In an embodiment, the thickness d3 of the third lower electrode LE3 may be greater than the thickness d2 of the second lower electrode LE2, and the second filling layer FL-22 disposed between the second lower electrode LE2 and the third lower electrode LE3 may have an inclined shape such that the thickness of the second filling layer FL-22 becomes greater as getting closer to the third lower electrode LE3 from the second lower electrode LE2. That is, the second filling layer FL-22 may include a third portion adjacent to the second lower electrode LE2 and a fourth portion adjacent to the third lower electrode LE3, and the thickness of the fourth portion may be greater than the thickness of the third portion.

That is, the first filling layer FL-21 may include a first portion adjacent to the first lower electrode LE1 and a second portion adjacent to the second lower electrode LE2, and the thickness of the second portion may be greater than the thickness of the first portion. In an embodiment, the thickness d3 of the third lower electrode LE3 may be greater than the thickness d2 of the second lower electrode LE2, and the second filling layer FL-22 disposed between the second lower electrode LE2 and the third lower electrode LE3 may have an inclined shape such that the thickness of the second filling layer FL-22 becomes greater as getting closer to the third lower electrode LE3 from the second lower electrode LE2. That is, the second filling layer FL-22 may include the third portion adjacent to the second lower electrode LE2 and the fourth portion adjacent to the third lower electrode LE3, and the thickness of the fourth portion may be greater than the thickness of the third portion.

A display panel according to an embodiment includes a filling layer disposed between a plurality of lower electrodes, and the filling layer covers a side surface of each of the lower electrodes and is not disposed on an upper surface of each of the lower electrodes. In addition, the filling layer includes a first organic material such as siloxane, polyimide, an acrylate-based polymer, etc., and a first inorganic material which is a silicon-based inorganic material such as silicon dioxide (SiO₂), silicon nitride (Si₃N₄), silicon oxynitride (SiON), and the like. Therefore, the display panel has a structure in which the filling layer fills stepped portions between the plurality of lower electrodes, a stepped structure formed by the organic layer, the upper electrode, etc., which are disposed above the lower electrodes, is reduced, and thus defects such as an upper electrode disconnection may be prevented.

More specifically, in a high-resolution display panel having a narrow interval between lower electrodes, it is difficult for a typical organic pixel-defining film or inorganic pixel-defining film to be patterned. Particularly, when the lower electrodes are different in thickness from each other, it is difficult to form a pixel-defining film for reducing stepped portions caused by the lower electrodes and stepped portions occurring between the lower electrodes, and thus defects that the upper electrode, etc., disposed above the lower electrodes are disconnected due to the stepped portions may occur. In the display panel according to an embodiment of the invention, since a filling layer, including an organic material such as siloxane, polyimide, and an acrylate-based polymer and a silicon-based inorganic material such as silicon dioxide (SiO₂), silicon nitride (Si₃N₄), and silicon oxynitride (SiON), is employed, the stepped portions caused by the lower electrodes and the stepped portions occurring between the lower electrodes are reduced to prevent the defects of disconnection of the upper electrode, and thus improves the durability and reliability of the display panel, and also a high-resolution display panel may be achieved.

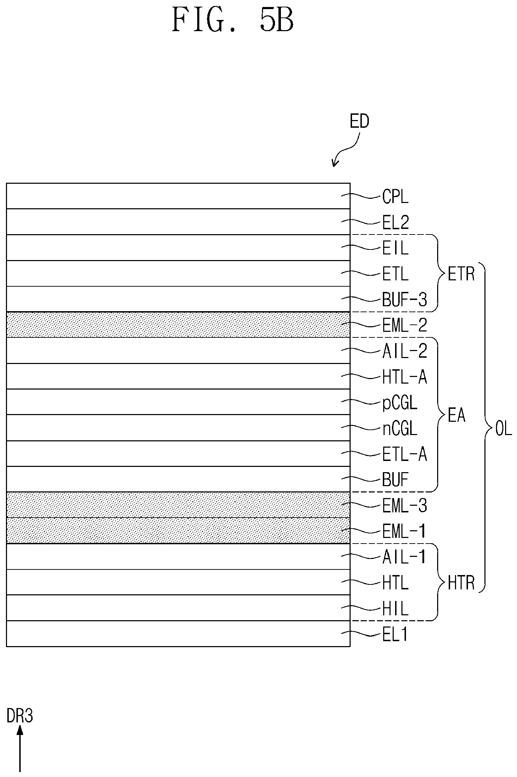

FIGS. 5A and 5B are cross-sectional views of a light-emitting element, respectively, according to an embodiment. FIGS. 5A and 5B each specifically illustrate an organic layer OL included in a light-emitting element ED according to the invention. The description of the light-emitting element ED to be made with reference to FIGS. 5A and 5B may be similarly applied to the first to third light-emitting elements ED-1, ED-2, and ED-3 of FIGS. 3 and 4A to 4C.

Referring to FIGS. 5A and 5B, the organic layer OL according to an embodiment may include a hole transport region HTR, a first light-emitting layer EMI,-1, an auxiliary light-emitting portion EA, a second light-emitting layer EML-2, a third light-emitting layer EMI,-3, and an electron transport region ETR. In the light-emitting element ED, the hole transport region HTR, the first light-emitting layer EML-1, the auxiliary light-emitting portion EA, the second light-emitting layer EML-2, the third light-emitting layer EMI,-3, and the electron transport region ETR may each be provided as a common layer. The light-emitting element ED including the first light-emitting layer EMI,-1, the second light-emitting layer EMI,-2, and the third light-emitting layer EMI,-3, which generate light having different wavelength ranges, respectively, may emit white light. In an embodiment, the thickness of each of the hole transport region HTR, the auxiliary light-emitting portion EA, and the electron transport region ETR, which are included in the light-emitting element ED, may be provided to allow red light, green light, or blue light to undergo the nth-order resonance.

Since it is possible to deposit, without using a mask, the first to third light-emitting layers EML-1, EML-2, and EML-3 which are provided as common layers, a pixel having a smaller area may be formed. A number of pixels having smaller areas are disposed, on a plane, in the display panel DP according to an embodiment, and thus high resolution may be achieved.

In the light-emitting element ED, the hole transport region HTR may be provided on a first electrode EL1. The first electrode EL1 illustrated in FIGS. 5A and 5B may indicate the lower electrodes LE1, LE2, and LE3 which have been described with reference to FIG. 3 and FIGS. 4A to 4C. The hole transport region HTR may have a single layer formed of a single material, a single layer formed of a plurality of different materials, or a multi-layered structure having a plurality of layers formed of a plurality of different materials. In an embodiment, for example, the hole transport region HTR may include a phthalocyanine compound, such as copper phthalocyanine, N1,N1'-([1,1'-biphenyl]-4,4'-diyl)bis(N1-phenyl-N4,N4-di-m-tolylbenzene-1,4-diamine) ("DNTPD"), 4,4',4"-[tris(3-methylphenyl)phenylamino] triphenylamine ("m-MTDATA"), 4,4',4"-tris(N,N-diphenylamino)triphenylamine ("TDATA"), 4,4',4"-tris[N(2-naphthyl)-N-phenylamino]-triphenylamine ("2-TNATA"), poly(3,4-ethylenedioxythiophene)/poly(4-styrenesulfonate) ("PEDOT/PSS"), polyaniline/dodecylbenzenesulfonic acid ("PANI/DBSA"), polyaniline/camphor sulfonic acid ("PANI/CSA"), polyaniline/poly(4-styrenesulfonate) ("PANI/PSS"), N,N'-di(naphthalene-1-yl)-N,N'-diphenyl-benzidine ("NPB"), triphenylamine-containing polyetherketone ("TPAPEK"), 4-isopropyl-4'-methyldiphenyliodonium [tetrakis(pentafluorophenyl)borate], dipyrazino[2,3-f: 2',3'-h] quinoxaline-2,3,6,7,10,11-hexacarbonitrile ("HATCN"), and the like.

In addition, the hole transport region HTR may include a carbazole-based derivative, such as N-phenylcarbazole, polyvinylcarbazole, a fluorene-based derivative, a triphenylamine-based derivative, such as N,N'-bis(3-methylphenyl)-N,N'-diphenyl-[1,1'-biphenyl]-4,4'-diamine ("TPD"), 4,4',4"-tris(N-carbazolyl)triphenylamine ("TCTA"), 4,4'-cyclohexylidene bis[N,N-bis(4-methylphenyl)benzenamine] ("TAPC"), 4,4'-bis[N,N'-(3-tolyl)amino]-3,3'-dimethylbiphenyl ("HMTPD"), 9-(4-tert-butylphenyl)-3,6-bis(triphenylsilyl)-9H-carbazole (CzSi), 9-phenyl-9H-3,9'-bicarbazole ("CCP"), 1,3-bis(N-carbazolyl)benzene ("mCP"), 1,3-bis(1,8-dimethyl-9H-carbazol-9-yl)benzene ("mDCP"), or the like.

The hole transport region HTR may further include, in addition to the above-described materials, a charge generation material to improve conductivity. The charge generation material may be uniformly or non-uniformly dispersed within the hole transport region HTR. In an embodiment, for example, the charge generation material may be a p-dopant. The p-dopant may include at least one of a metal halide compound, a quinone derivative, a metal oxide, or a cyano group containing-compound, but is not limited thereto. In another embodiment, for example, the p-dopant may include a metal halide compound, such as CuI and RbI, a quinone derivative, such as tetracyanoquinodimethane ("TCNQ") and 2,3,5,6-tetrafluoro-7,7'8,8-tetracyanoquinodimethane ("F4-TCNQ"), a metal oxide, such as a tungsten oxide and a molybdenum oxide, and a cyano group-containing compound such as dipyrazino[2,3-f: 2',3'-h] quinoxaline-2,3,6,7,10,11-hexacarbonitrile ("HATCN") and 4-[[2,3-bis[cyano-(4-cyano-2,3,5,6-tetrafluorophenyl)methylidene]cyclopropylidene]-cyanomethyl]-2,3,5,6-tetrafluorobenzonitrile ("NDP9"), but an embodiment of the invention is not limited thereto.

The hole transport region HTR may include a hole injection layer HIL, a first hole transport layer HTL, and a first sub-hole control layer AIL-1 which are sequentially stacked. Unlike what is illustrated, at least one of the hole injection layer HIL, the first hole transport layer HTL, or the first sub-hole control layer AIL-1 may be omitted. The hole injection layer HIL, the first hole transport layer HTL, and the first sub-hole control layer AIL-1 may include the compounds of the above-described hole transport region HTR.

The first sub-hole control layer AIL-1 may be disposed adjacent to the first light-emitting layer EML-1 which generates the first light. The first sub-hole control layer AIL-1 may be formed to have a lowest unoccupied molecular orbital ("LUMO") energy level and a highest occupied molecular orbital ("HOMO") energy level at which holes are easily transferred. Accordingly, it is possible to prevent an increase in a driving voltage of the light-emitting element ED including the first sub-hole control layer AIL-1. In addition, the first sub-hole control layer AIL-1 may block electrons from transferring from the first light-emitting layer EML-1 to the hole transport region HTR. Therefore, a display panel DP including the light-emitting element ED including the first sub-hole control layer AIL-1 may have improved display lifetime.

The electron transport region ETR may be disposed on the auxiliary light-emitting portion EA. The electron transport region ETR may have a single layer formed of a single material, a single layer formed of a plurality of different materials, or a multi-layered structure having a plurality of layers formed of a plurality of different materials.

In an embodiment, for example, the electron transport region ETR may include an anthracene-based compound. However, an embodiment of the invention is not limited thereto, and the electron transport region ETR may include tris(8-hydroxyquinolinato)aluminium (Alq₃), 1,3,5-tri[(3-pyridyl)-phen-3-yl]benzene, 2,4,6-tris(3 '-(pyridin-3 -yl)biphenyl-3 -yl)-1,3,5-triazine, 2-(4-(N-phenylbenzoimidazol-1 - yl)phenyl)-9,10-dinaphthylanthracene, 1,3,5-tri(1-phenyl-1H-benzo[d]imidazol-2-yl)benzene ("TPBi"), 2,9-dimethyl-4,7-diphenyl-1,10-phenanthroline ("BCP"), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole ("NTAZ"), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), berylliumbis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), and a mixture thereof.

In addition, the electron transport region ETR may include a halogenated metal, such as LiF, NaCl, CsF, RbCl, RbI, CuI, and KI, a lanthanide metal, such as Yb, or also a co-deposited material of the halogenated metal and the lanthanide metal. In an embodiment, for example, the electron transport region ETR may include KI:Yb, RbLYb, LiF:Yb, etc., as a co-deposited material. A metal oxide such as Li₂O and BaO, 8-hydroxyl-Lithium quinolate (Liq), or the like is used for the electron transport region ETR, but an embodiment of the invention is not limited thereto. The electron transport region ETR may be composed of a mixture of an electron transport material and an organo metal salt having an insulation property. The organo metal salt may be a material having an energy band gap of about 4 eV or more. In an embodiment, for example, specifically, the organo metal salt may include metal acetate, metal benzoate, metal acetoacetate, metal acetylacetonate, or metal stearate.

In an embodiment, the electron transport region ETR may further include, in addition to the above-described materials, at least one of 2,9-dimethyl-4,7-diphenyl-1,10-phenanthroline (BCP), diphenyl(4-(triphenylsilyl)phenyl)phosphine oxide ("TSPO1"), or 4,7-diphenyl-1,10-phenanthroline (Bphen), but an embodiment of the invention is not limited thereto.

The electron transport region ETR may include a second buffer layer BUF-3, a first electron transport layer ETL, and an electron injection layer EII, which are sequentially stacked. Unlike what is illustrated, at least one of the first buffer layer BUF-3, the first electron transport layer ETL, or the electron injection layer EIL may be omitted. The second buffer layer BUF-3, the first electron transport layer ETL, and the electron injection layer EII, may include the compounds of the above-described electron transport region ETR. The second buffer layer BUF-3 may block holes from transferring from the third light-emitting layer EML-3 to the electron transport region ETR.

The auxiliary light-emitting portion EA, disposed between the first light-emitting layer EML-1 and the second light-emitting layer EMI,-2, may include a first buffer layer BUF, a second electron transport layer ETL-A, a first charge generation layer nCGL, a second charge generation layer pCGL, a second hole transport layer HTL-A, and a second sub-hole control layer AIL-2, which are sequentially stacked. The first charge generation layer nCGL may be an n-type charge generation layer, and the second charge generation layer pCGL may be a p-type charge generation layer. Unlike what is illustrated, at least one of the first buffer layer BUF, the second electron transport layer ETL-A, the first charge generation layer nCGL, the second charge generation layer pCGL, the second hole transport layer HTL-A, or the second sub-hole control layer AIL-2 may be omitted.

The second sub-hole control layer AIL-2 may include a material different from a material of the above-described first sub-hole control layer AIL-1. The second sub-hole control layer AIL-2 may include a material for assisting the second light-emitting layer EML-2 in generating the second light, or a material for assisting the third light-emitting layer EML-3 in generating the third light. The first sub-hole control layer AIL-1 may include a material for assisting the first light-emitting layer EML-1 in generating the first light. However, an embodiment of the invention is not limited thereto, and the first sub-hole control layer AIL-1 and the second sub-hole control layer AIL-2 may include the same material in another embodiment.

The second sub-hole control layer AIL-2 may be disposed adjacent to the third light-emitting layer EML-3 which generates the third light or to the second light-emitting layer EML-2 which generates the second light. The second sub-hole control layer AIL-2 may be formed to have a lowest unoccupied molecular orbital (LUMO) energy level and a highest occupied molecular orbital (HOMO) energy level at which holes are easily transferred. Accordingly, it is possible to prevent an increase in a driving voltage of the light-emitting element ED including the second sub-hole control layer AIL-2. In addition, the second sub-hole control layer AIL-2 may block electrons from transferring from the second light-emitting layer EML-2 or the third light-emitting layer EML-3 to the second hole transport layer HTL-A. Therefore, the display lifetime of the display panel DP including the light-emitting element ED including the second sub-hole control layer AIL-2 may be effectively improved.

A second electrode EL2 may be provided on the organic layer OL. The second electrode EL2 illustrated in FIGS. 5A and 5B may indicate the upper electrode UE illustrated in FIG. 3. The second electrode EL2 may include: at least one selected from among Ag, Mg, Cu, Al, Pt, Pd, Au, Ni, Nd, Ir, Cr, Li, Ca, LiF, Mo, Ti, W, In, Sn, or Zn; a compound of two or more materials selected from thereamong; a mixture of two or more materials selected from thereamong; or an oxide thereof. The second electrode EL2 may be a transmissive electrode, a transflective electrode, or a reflective electrode. When the second electrode EL2 is a transmissive electrode, the second electrode EL2 may be composed of a transparent metal oxide, for example, indium tin oxide (ITO), indium zinc oxide (IZO), zinc oxide (ZnO), indium tin zinc oxide (ITZO), and the like in an embodiment.

When the second electrode EL2 is a transflective electrode or a reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, and W, or a compound or mixture thereof (for example, AgMg, AgYb, or MgYb). In addition, the second electrode EL2 may have a multilayer structure including a reflective film or a transflective film, which is formed of the above-described material, and a transparent conductive film formed of indium tin oxide (ITO), indium zinc oxide (IZO), zinc oxide (ZnO), indium tin zinc oxide (ITZO), and the like. In an embodiment, for example, the second electrode EL2 may include the above-described metal material, a combination of two or more metal materials selected from among the above-described metal materials, an oxide of the above-described metal materials, or the like.

A capping layer CPL may be provided on the second electrode EL2. The capping layer CPL may have a multi- or single-layered structure. The capping layer CPL may be an organic layer or an inorganic layer. In an embodiment, for example, when the capping layer CPL includes an inorganic material, the inorganic material may include an alkali metal compound, such as LiF, an alkaline earth metal compound, such as MgF₂, SiON, SiN_{X}, SiO_{y}, and the like. On the other hand, when the capping layer CPL includes an organic material, the organic material may include α-NPD, NPB, TPD, m-MTDATA, Alq₃, CuPc, N4,N4,N4',N4'-tetra (biphenyl-4-yl) biphenyl-4,4'-diamine (TPD15), 4,4',4"-tris (carbazol-9-yl) triphenylamine (TCTA), etc., or include an epoxy resin or acrylate such as methacrylate.

Referring to FIG. 5A, in an embodiment, the first light-emitting layer EML-1 may be disposed on the hole transport region HTR. The second light-emitting layer EML-2 may be disposed on the auxiliary light-emitting portion EA. The third light-emitting layer EML-3 may be disposed between the second light-emitting layer EML-2 and the auxiliary light-emitting portion EA. Referring to FIG. 5B, in an embodiment, the first light-emitting layer EML-1 may be disposed on the hole transport region HTR, the second light-emitting layer EML-2 may be disposed on the auxiliary light-emitting portion EA, and the third light-emitting layer EML-3 may be disposed between the first light-emitting layer EML-1 and the auxiliary light-emitting portion EA. However, this is merely an example, and an embodiment of the invention is not limited thereto.

The first light-emitting layer EML-1 may generate blue light, the second light-emitting layer EML-2 may generate red light, and the third light-emitting layer EML-3 may generate green light. Unlike this, the first light-emitting layer EML-1 may generate green light, the second light-emitting layer EML-2 may generate blue light, and the third light-emitting layer EML-3 may generate red light. Alternatively, the first light-emitting layer EML-1 may generate red light, the second light-emitting layer EML-2 may generate green light, and the third light-emitting layer EML-3 may generate blue light.

Hereinafter, a method of manufacturing a display panel according to an embodiment will be described with reference to the accompanying drawings. With regard to the description of the method of manufacturing the display panel according to an embodiment, the duplicated contents of the above-described display panel according to an embodiment will be omitted.

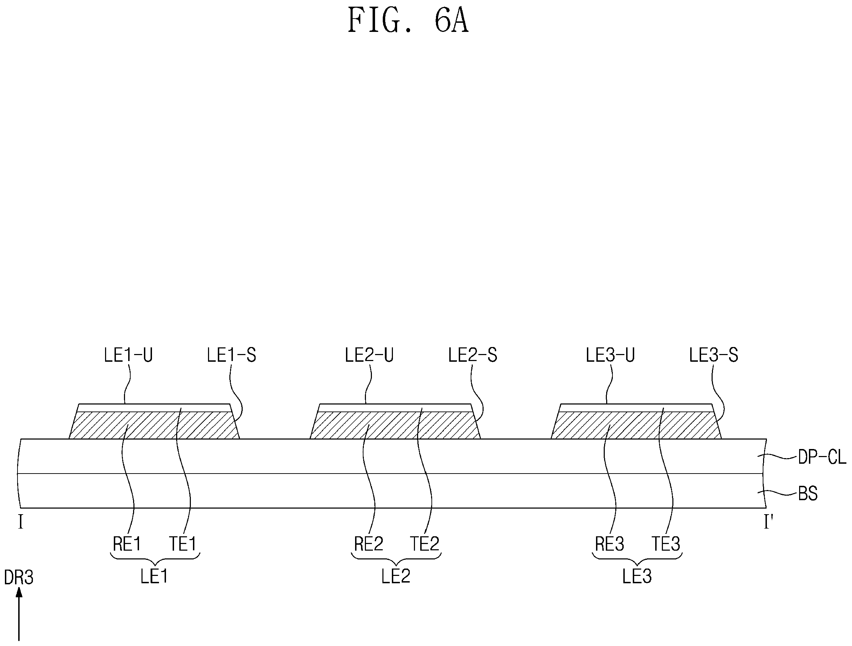

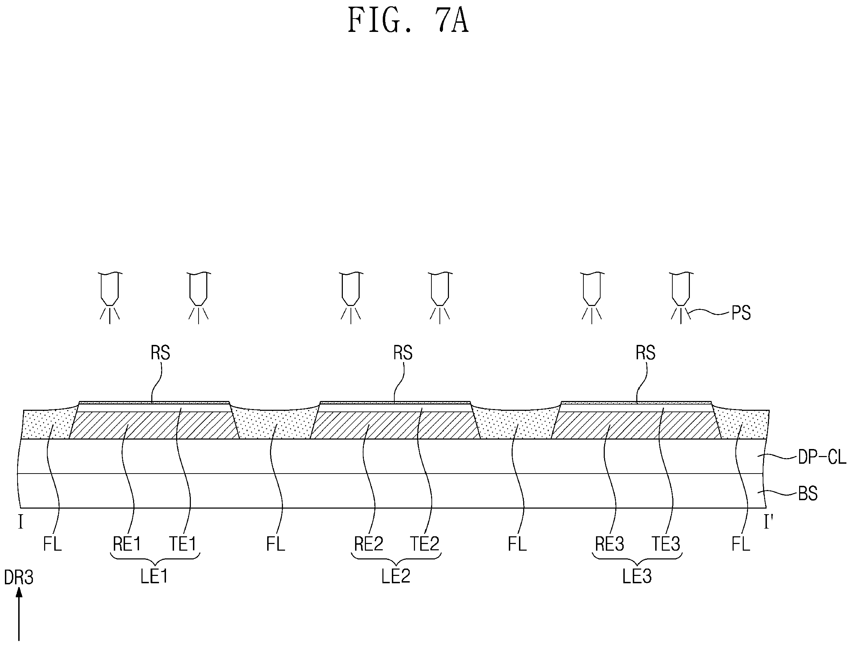

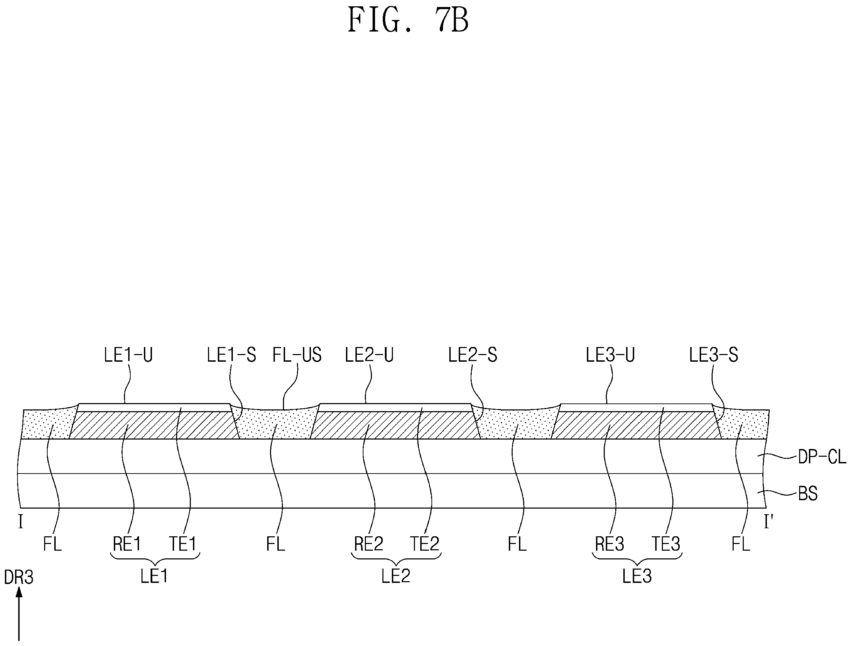

FIGS. 6A to 6C are cross-sectional views illustrating some operations of a method of manufacturing a display panel according to an embodiment of the invention. FIGS. 7A and 7B are cross-sectional views illustrating some operations of a method of manufacturing a display panel according to an embodiment of the invention. FIGS. 6A to 6C, and FIGS. 7A and 7B each illustrate one state in some operations of the method of manufacturing the display panel, compared to the cross section of FIG. 4A.

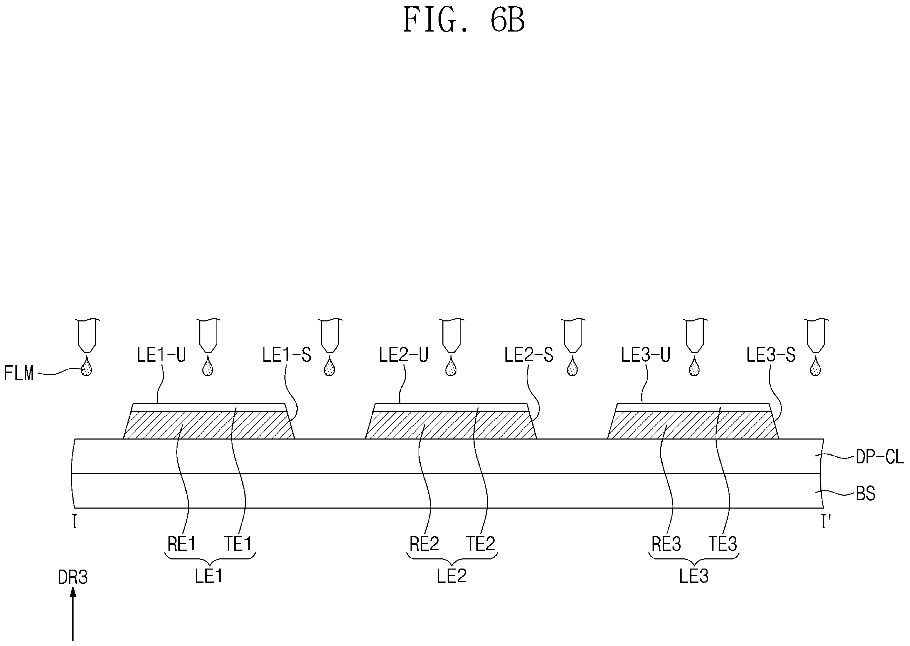

Referring to FIGS. 6A and 6B together, the method of manufacturing the display panel according to an embodiment includes providing a preliminary display panel, including a base layer BS and a plurality of lower electrodes LE1, LE2, and LE3 disposed on the base layer BS, and providing a filling material FLM on the preliminary display panel.

In the preliminary display panel, a circuit layer DP-CL is disposed on the base layer BS, and the plurality of lower electrodes LE1, LE2, and LE3 may be disposed on the circuit layer DP-CL.

The base layer BS may be a rigid substrate or a flexible substrate capable of bending, folding, rolling, and the like. The base layer BS may be a glass substrate, a metal substrate, a polymer substrate, or the like. However, an embodiment of the invention is not limited thereto, and the base layer BS may be an inorganic layer, an organic layer, or a composite material layer in another embodiment. The circuit layer DP-CL may include an insulating layer, a semiconductor pattern, a conductive pattern, a signal line, and the like. After an insulating layer, a semiconductor layer, and a conductive layer are formed on the base layer BS through coating, deposition, etc., the insulating layer, the semiconductor layer, and the conductive layer may be selectively patterned by performing a photolithography process multiple times. Thereafter, the semiconductor pattern, the conductive pattern, and the signal line included in the circuit layer DP-CL may be formed.

The lower electrodes LE1, LE2, and LE3 may be disposed on the circuit layer DP-CL and include a first lower electrode LE1, a second lower electrode LE2, and a third lower electrode LE3. The first lower electrode LE1, the second lower electrode LE2, and the third lower electrode LE3 may be disposed to be spaced apart from each other. The first lower electrode LE1, the second lower electrode LE2, and the third lower electrode LE3 may each be disposed on the circuit layer DP-CL. The first lower electrode LE1, the second lower electrode LE2, and the third lower electrode LE3 may each be disposed on the uppermost layer among a plurality of insulating layers included in the circuit layer DP-CL.

The first lower electrode LE1, the second lower electrode LE2, and the third lower electrode LE3 may include first layers RE1, RE2, and RE3 and second layers TE1, TE2, and TE3 which are sequentially stacked, respectively. The first lower electrode LE1, the second lower electrode LE2, and the third lower electrode LE3 may each include one electrode having a two-layered structure in which the first layers RE1, RE2, and RE3 and the second layers TE1, TE2, and TE3 are stacked. The first lower electrode LE1 may include a (1-1)-th layer RE1 and a (2-1)-th layer TE1, the second lower electrode LE2 may include a (1-2)-th layer RE2 and a (2-2)-th layer TE2, and the third lower electrode LE3 may include a (1-3)-th layer RE3 and a (2-3)-th layer TE3.

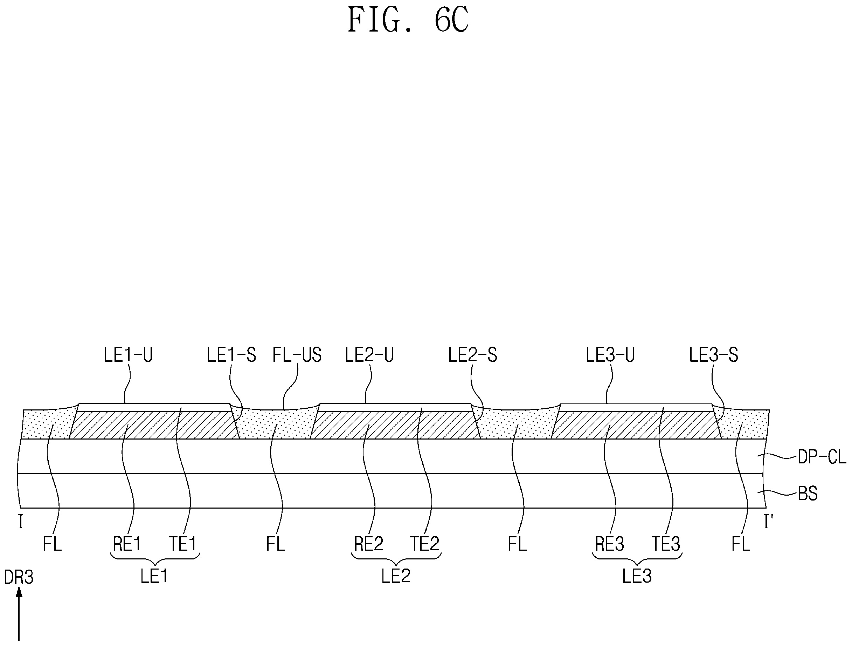

Referring FIGS. 6B and 6C together, a filling layer FL may be formed through the operation of providing the filling material FLM on the preliminary display panel. The filling layer FL may be formed between the lower electrodes LE1, LE2, and LE3. The filling layer FL may be formed to be disposed between the lower electrodes LE1, LE2, and LE3 and to cover at least a portion of each of side surfaces LE1-S, LE2-S, and LE3-S of the lower electrodes LE1, LE2, and LE3. The filling layer FL may be formed to cover each of a first electrode side surface LE1-S of the first lower electrode LE1, a second electrode side surface LE2-S of the second lower electrode LE2, and a third electrode side surface LE3-S of the third lower electrode LE3.

The filling layer FL may be formed not to be disposed on each of upper surfaces LE1-U, LE2-U, and LE3-U of the lower electrodes LE1, LE2, and LE3. The filling layer FL may be formed to be disposed on neither the first electrode upper surface LE1-U of the first lower electrode LE1, the second electrode upper surface LE2-U of the second lower electrode LE2, nor the third electrode upper surface LE3-U of the third lower electrode LE3. In an embodiment, the patterned filling material FLM for forming the filling layer FL is not provided only between the lower electrodes LE1, LE2, and LE3, but may be provided above the lower electrodes LE1, LE2, and LE3 and between the lower electrodes LE1, LE2, and LE3 in common. Since the filling material FLM has flowability, the filling material FLM provided above the lower electrodes LE1, LE2, and LE3 may flow between the lower electrodes LE1, LE2, and LE3, and then may be cured and formed as the filling layer FL.

The filling material FLM includes a first inorganic material and a first organic material. The first inorganic material included in the filling material FLM is an inorganic material including silicon. In embodiment, the first inorganic material included in the filling material FLM may include at least one of silicon dioxide (SiO₂), silicon nitride (Si₃N₄), or silicon oxynitride (SiON). In an embodiment, for example, the first inorganic material may be silicon dioxide (SiO₂). The first organic material included in the filling material FLM may include at least one of siloxane, polyimide, or an acrylate-based polymer. For example, the first organic material may be siloxane. The filling layer FL may be composed of the first inorganic material and the first organic material.

With regard to the first organic material and the first inorganic material included in the filling material FLM, the amount of the first inorganic material may be greater than the amount of the first organic material with respect to amounts of the first inorganic material and the first organic material included in the filling material FLM. The first organic material may be included in an amount of about 10 wt% to about 50 wt% with respect to the amounts of the first inorganic material and the first organic material included in the filling material FLM.

The weight ratio of the solid content included in the filling material FLM may be about 2 wt% or less. The filling material FLM may further include a solvent in addition to the above-described first organic material and first inorganic material. With respect to the total content of the filling material FLM, the first organic material and the first inorganic material, which are solid contents, may be in amounts of about 2 wt% or less. When the weight ratio of the solid content included in the filling material FLM is greater than about 2 wt%, the flowability of the filling material FLM may be deteriorated, and thus the filling material FLM provided above the lower electrodes LE1, LE2, and LE3 may not flow between the lower electrodes LE1, LE2, and LE3 and remain.

The filling material FLM may be composed of the first organic material, the first inorganic material, and the solvent. The filling material FLM may not include other materials except for the first organic material, the first inorganic material, and the solvent. In an embodiment, the filling material FLM may not include a photosensitizer. During the process of curing the filling material FLM to form the filling layer FL, the filling material FLM does not include a photosensitizer, and therefore an additional exposure process may not be performed. The filling material FLM may be naturally cured or thermally cured and formed as the filling layer FL.

Referring to FIGS. 6B, 7A, and 7B together, in the operation of providing the filling material FLM to form the filling layer FL, a residue RS may be formed on the lower electrodes LE1, LE2, and LE3. The residue RS may be formed by being cured in a state where the filling material FLM provided on the lower electrodes LE1, LE2, and LE3 does not flow between the lower electrodes LE1, LE2, and LE3 and remain. FIG. 7A exemplarily illustrates that the residue RS is formed on the first lower electrode LE1, the second lower electrode LE2, and the third lower electrode LE3. However, an embodiment of the invention is not limited thereto, and the residue RS may be formed on only a portion of the first lower electrode LE1, the second lower electrode LE2, and the third lower electrode LE3 in another embodiment. In addition, FIG. 7A exemplarily illustrates that the residue RS has a layered structure. However, an embodiment of the invention is not limited thereto, and the residue RS may be formed in various patterns.

The method of manufacturing the display panel according to an embodiment may further include, after the operation of forming the filling layer FL, ashing the upper surfaces LE1-U, LE2-U, and LE3-U of the lower electrodes LE1, LE2, and LE3. In an embodiment, for example, the ashing process may be a process for removing, by using plasma PS (i.e., dry ashing), the residue RS formed on each of the upper surfaces LE1-U, LE2-U, and LE3-U of the lower electrodes LE1, LE2, and LE3. Since the residue RS formed on each of the upper surfaces LE1-U, LE2-U, and LE3-U of the lower electrodes LE1, LE2, and LE3 is removed through the plasma ashing process, the upper surfaces LE1-U, LE2-U, and LE3-U of the lower electrodes LE1, LE2, and LE3 may be exposed. Therefore, the filling layer FL is disposed to be in contact only with each of side surfaces LE1-S, LE2-S, and LE3-S of the lower electrodes LE1, LE2, and LE3, and may be formed so as not to be in contact with the upper surfaces LE1-U, LE2-U, and LE3-U.

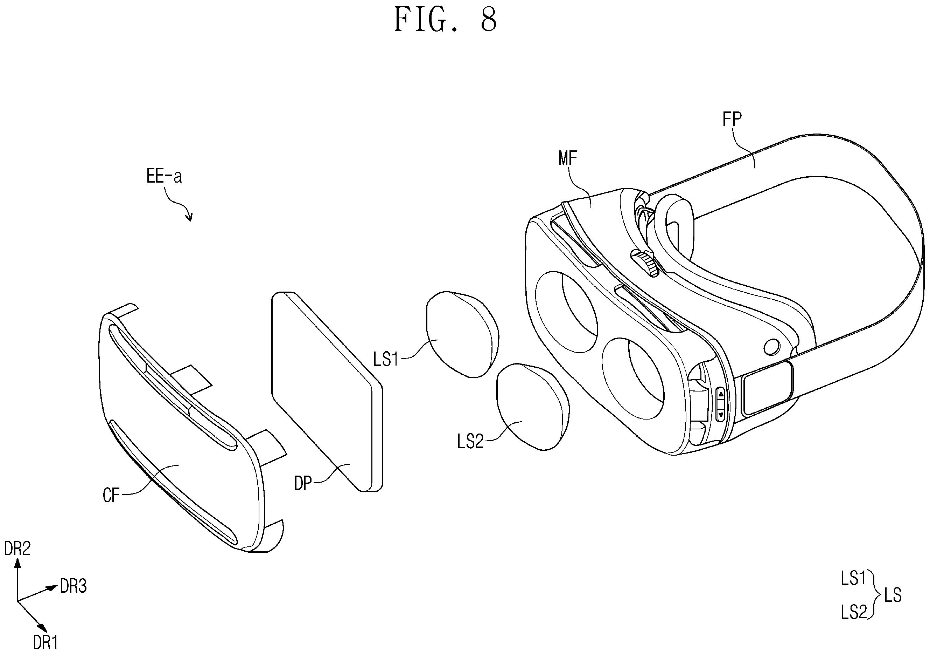

FIG. 8 is a perspective view of an electronic device according to an embodiment of the invention.

In FIG. 8, a head mounted display ("HMD") is illustrated as one example of an electronic device EE-a. The head mounted display may be a device which is mounted on a user's head and provides a screen on which an image or video is displayed to a user. The head mounted display may include a see-through type display which provides augmented reality ("AR") on the basis of actual external objects and a see-closed type display which provides virtual reality ("VR") to a user on a screen independent of external objects.

Referring to FIG. 8, the electronic device EE-a may include a display panel DP and a lens part LS facing the display panel DP. In addition, the electronic device EE-a may include a main frame MF, a cover frame CF, and a fixing part FP.

The main frame MF may be a part worn on a user's face. The main frame MF may have a shape corresponding to a shape of a user's head (face). In an embodiment, for example, the length of the fixing part FP may be adjusted according to a circumference of a user's head. The fixing part FP is a component with which the installation of the main frame MF is facilitated, and may include a strap, a belt, and the like. However, an embodiment of the invention is not limited thereto, and the fixing part FP may have various shapes such as a helmet, an eyeglass temple, etc., which are coupled to the main frame MF.

The lens part LS, the display panel DP, and the cover frame CF may be mounted on the main frame MF. The main frame MF may have a space or a structure in which the lens part LS and the display panel DP are accommodated.

The lens part LS may be disposed between the display panel DP and a user. The lens part LS may allow light emitted from the display panel DP to pass therethrough and be provided to the user. In an embodiment, for example, the lens part LS may include various types of lenses such as a multi-channel lens, a convex lens, a concave lens, a spherical lens, an aspheric lens, a single lens, a compound lens, a standard lens, a narrow-angle lens, a wide-angle lens, a fixed-focus lens, and a variable-focus lens.

The lens part LS may include a first lens LS1 and a second lens LS2. The first lens LS1 and the second lens LS2 may be disposed to correspond to positions of user's left and right eyes. The first lens LS1 and the second lens LS2 may be accommodated inside the main frame MF.

The display panel DP may be provided to the main frame MF in a fixed state or in an attachable/detachable manner. The display panel DP has already been described above in more detail.

The cover frame CF may be disposed on one surface of the display panel DP and protect the display panel DP. The cover frame CF and the lens part LS may be spaced apart from each other with the display panel DP therebetween.

According to a display panel of an embodiment of the invention, a high-resolution display panel having a narrow interval between lower electrodes may be achieved. Also, stepped portions caused by the lower electrodes and stepped portions occurring between the lower electrodes may be easily removed, thereby preventing defects of disconnection of an upper electrode disposed above the lower electrode. Therefore, the durability and reliability of the display panel may be effectively improved.

Although the embodiments of the invention have been described, it is understood that the invention should not be limited to these embodiments but various changes and modifications can be made by one ordinary skilled in the art within the scope of the invention as hereinafter claimed. Therefore, the technical scope of the invention is not limited to the contents described in the detailed description of the specification, but should be determined by the claims.

## Claims

1. A display panel comprising:
a base layer including a display region and a non-display region, wherein the display region has a first light-emitting region, a second light-emitting region, and a non-light-emitting region;
a first lower electrode disposed on the base layer and overlapping the first light-emitting region;
a second lower electrode disposed on the base layer and overlapping the second light-emitting region; and
a filling layer disposed on the base layer and between the first lower electrode and the second lower electrode,
wherein the filling layer includes an inorganic material containing silicon and an organic material, and covers at least a portion of a side surface of each of the first lower electrode and the second lower electrode.

2. The display panel of claim 1, wherein the filling layer is not disposed above each of the first lower electrode and the second lower electrode.

3. The display panel of claim 1 or claim 2, wherein the organic material comprises at least one of siloxane, polyimide, or an acrylate-based polymer, and
the inorganic material comprises at least one of silicon dioxide (SiO₂), silicon nitride (Si₃N₄), or silicon oxynitride (SiON).

4. The display panel of any one of claims 1 to 3, wherein the filling layer contains the organic material in an amount of about 10 percentage by weight (wt%) to about 50 wt% with respect to a total content of the filling layer.

5. The display panel of any one of claims 1 to 4, wherein the first lower electrode comprises a first electrode upper surface, the second lower electrode comprises a second electrode upper surface, and the filling layer comprises an upper surface; and
the upper surface of the filling layer is disposed lower than at least one of the first electrode upper surface or the second electrode upper surface.

6. The display panel of claim 5, wherein the upper surface of the filling layer has a recessed curved shape such that the upper surface of the filling layer becomes more adjacent to the base layer in a direction away from each of the first electrode upper surface and the second electrode upper surface.

7. The display panel of any one of claims 1 to 3, wherein the first lower electrode has a first thickness, and
the second lower electrode has a second thickness different from the first thickness.

8. The display panel of claim 7, wherein the second thickness is larger than the first thickness,
the filling layer comprises a first portion adjacent to the first lower electrode; and a second portion adjacent to the second lower electrode, and
a thickness of the second portion is greater than a thickness of the first portion.

9. The display panel of any one of claims 1 to 8, wherein the display region further comprises a third light-emitting region,
the display panel further comprises a third lower electrode disposed on the base layer and overlapping the third light-emitting region, and
the filling layer is disposed between the second lower electrode and the third lower electrode.

10. The display panel of claim 9, wherein a thickness of the third lower electrode is different from each of a thickness of the first lower electrode and a thickness of the second lower electrode.

11. The display panel of any one of claims 1 to 10, wherein the first lower electrode and the second lower electrode each comprise:
a first layer including a reflective metal material; and
a second layer disposed on the first layer and including a transparent conductive oxide.

12. The display panel of claim 11, wherein the filling layer is in contact with a side surface of each of the first layer and the second layer.

13. The display panel of any one of claims 1 to 12, further comprising:
at least one organic layer disposed on the first lower electrode and the second lower electrode and including a light-emitting layer; and
an upper electrode disposed on the at least one organic layer.

14. The display panel of any one of claims 1 to 13, wherein the filling layer is in contact with the side surface of each of the first lower electrode and the second lower electrode and comprises a lower surface aligned with a lower surface of each of the first lower electrode and the second lower electrode.

15. A method of manufacturing a display panel, the method comprising:
providing a preliminary display panel including a base layer, a first lower electrode disposed on the base layer, and a second lower electrode disposed on the base layer and spaced apart from the first lower electrode; and
providing a filling material between the first lower electrode and the second lower electrode to form a filling layer,
wherein the filling material includes an inorganic material containing silicon and an organic material, and
the filling layer is formed to cover at least a portion of a side surface of each of the first lower electrode and the second lower electrode.
